# FASCICULE DE BREVET EUROPEEN

(11) **EP 3 631 392 B1**
(45) Date de publication et mention de la délivrance du brevet: **03.03.2021**
(21) Numéro de dépôt: 18727710.8
(22) Date de dépôt: 15.05.2018
(51) Int. Cl.: G01J 5/06, H01L 23/552

(54) **ENSEMBLE DE BLINDAGE ELECTROMAGNETIQUE TRANSPARENT OPTIQUEMENT**
OPTISCH TRANSPARENTE ELEKTROMAGNETISCHE ABSCHIRMUNGSANORDNUNG
OPTICALLY TRANSPARENT ELECTROMAGNETIC SHIELD ASSEMBLY

(30) Priorité: 22.05.2017 FR 1754537
(43) Date de publication de la demande: 08.04.2020
(73) Titulaire: Safran Electronics & Defense, 75015 Paris (FR); Centre National de la Recherche Scientifique - CNRS, 75016 Paris (FR); Université de Rennes 1, 35000 Rennes (FR)
(72) Inventeur: DUPEYRAT, Cyril, 92100 Boulogne Billancourt (FR); FOUTREL, Patrice, 92100 Boulogne Billancourt (FR); BESNIER, Philippe, 92100 Boulogne Billancourt (FR); CASTEL, Xavier, 92100 Boulogne Billancourt (FR); CORREDORES, Yonathan, 92100 Boulogne Billancourt (FR)
(74) Mandataire: Plasseraud IP
(86) Numéro de dépôt international: PCT/EP2018/062529
(87) Numéro de publication internationale: WO 2018/215243

(56) Documents cités:
- WO-A1-2015/199624
- CORREDORES YONATHAN ET AL: "Adjustment of Shielding Effectiveness, Optical Transmission, and Sheet Resistance of Conducting Films Deposited on Glass Substrates", IEEE TRANSACTIONS ON ELECTROMAGNETIC COMPATIBILITY, IEEE SERVICE CENTER, NEW YORK, NY, US, vol. 59, no. 4, 30 mars 2017 (2017-03-30), pages 1070-1078, XP011644021, ISSN: 0018-9375, DOI: 10.1109/TEMC.2017.2654269 [extrait le 2017-03-29]
- Kemtron: "Fenêtre optique à blindage électromagnétique", , 4 février 2016 (2016-02-04), XP055477343, Extrait de l'Internet: URL:http://www.kemtron.fr/kemtron/download s/product/kt-ds-f-fenetre-optique-a-blinda ge-electomagnetique.pdf [extrait le 2018-05-22]

## Description

La présente invention concerne un ensemble de blindage électromagnétique qui est transparent optiquement.

De nombreuses applications utilisent des capteurs optiques, par exemple des capteurs sensibles à des rayonnements optiques qui appartiennent au domaine infrarouge, alors que les fonctionnements de tels capteurs peuvent être perturbés par des rayonnements électromagnétiques, notamment du domaine hyperfréquence. De tels rayonnements hyperfréquences peuvent en effet interagir avec des circuits électroniques qui doivent être placés à proximité immédiate des capteurs, sans pouvoir être déportés dans des volumes étanches aux rayonnements hyperfréquences provenant de l'extérieur. Il est alors connu de disposer devant un tel capteur optique, un élément de blindage qui est au moins partiellement opaque pour une partie des rayonnements hyperfréquences, tout en étant au moins partiellement transparent pour les rayonnements optiques. Pour cela, l'élément de blindage comporte au moins une structure bidimensionnelle qui est conductrice électriquement, en étant au moins partiellement transparente pour les rayonnements optiques.

Pour procurer une protection efficace contre les rayonnements hyperfréquences, la structure bidimensionnelle conductrice doit en outre être reliée électriquement à une partie au moins d'une coque qui est aussi conductrice électriquement, et qui entoure le (les) capteur(s) à protéger. Cette partie de coque constitue une référence de potentiel électrique pour la structure bidimensionnelle conductrice. Elle peut être elle-même reliée électriquement à la masse électrique d'un support ou d'un véhicule sur lequel le (les) capteur(s) optique(s) est (sont) installé(s).

Plus précisément, un ensemble de blindage électromagnétique transparent optiquement tel que connu avant la présente invention, comprend :
- un substrat rigide, qui possède deux faces opposées, qui est au moins partiellement transparent entre ses deux faces pour au moins un rayonnement électromagnétique qui possède une fréquence f comprise entre 0,1 GHz (gigahertz) et 40 GHz, dit rayonnement hyperfréquence, et qui est aussi au moins partiellement transparent entre ses deux faces pour un rayonnement optique qui possède une longueur d'onde comprise entre 0,1 µm et 15 µm ;
- au moins une structure bidimensionnelle conductrice électriquement, qui est disposée sur au moins une des faces du substrat, et qui est au moins partiellement transparente pour le rayonnement optique ; et
- un dispositif de connexion électrique, qui connecte électriquement au moins une première borne à au moins une seconde borne, chaque première borne étant raccordée électriquement à la structure bidimensionnelle conductrice, et chaque seconde borne étant destinée à être raccordée électriquement à au moins une partie d'une coque qui est conductrice électriquement.

Les transmissions et transparences optiques considérées, pour le substrat et la structure bidimensionnelle conductrice, sont relatives au rayonnement optique qui est destiné à traverser le substrat muni de la structure bidimensionnelle conductrice.

En outre, l'efficacité de blindage, notée EB(f) et exprimée en décibels (dB), peut être définie par EB(f) = -10·log₁₀(T(f)), où T(f) est un coefficient de transmission énergétique de l'ensemble de blindage pour le rayonnement électromagnétique hyperfréquence qui possède une fréquence f comprise entre 0,1 GHz et 40 GHz, et qui est destiné à traverser le substrat muni de la structure bidimensionnelle conductrice, entre les deux faces du substrat.

Or différents systèmes de détection peuvent nécessiter des niveaux de blindage différents, correspondant à des valeurs différentes de l'efficacité de blindage pour la même fréquence f. Jusqu'à présent, un ensemble de blindage différent est conçu et produit pour chacun de ces systèmes de détection, dans lequel la structure bidimensionnelle est adaptée en fonction de la valeur requise pour l'efficacité de blindage. Mais une telle adaptation limite les séries d'ensembles de blindage qui sont fabriquées chacune pour une valeur différente de l'efficacité de blindage, et à cause de cela le prix unitaire de chaque ensemble de blindage ne peut pas être diminué.

Par ailleurs, certains systèmes de détection complexes comportent, en plus de capteurs optiques, des capteurs de rayonnements électromagnétiques qui sont efficaces dans la bande hyperfréquence, ou à proximité de celle-ci en termes de valeurs de fréquence. Il est alors nécessaire que le même ensemble de blindage qui est utilisé pour tous les capteurs du système de détection complexe réalise un compromis entre une efficacité de blindage suffisante et un niveau de transparence pour le rayonnement hyperfréquence qui permette le fonctionnement du ou des capteur(s) de rayonnement hyperfréquence. Or il existe des conditions dans lesquelles le rayonnement hyperfréquence qui est susceptible de traverser l'ensemble de blindage varie dans des proportions très importantes : entre des niveaux d'intensité faibles pour lesquels l'ensemble de blindage doit être suffisamment transparent pour ce rayonnement hyperfréquence, et des niveaux d'intensité très élevés contre lesquels l'ensemble de blindage doit produire une efficacité de blindage suffisante. Une telle situation se produit notamment pour un engin autodirecteur à l'approche d'une cible qui émet un rayonnement hyperfréquence de brouillage. Ce rayonnement hyperfréquence de brouillage possède alors une intensité qui augmente lorsque l'engin se rapproche de la cible, mais la cible peut être détectée simultanément en utilisant pour partie des capteurs qui sont sensibles dans le domaine spectral des rayonnements hyperfréquences, en plus de capteurs optiques. Or ces capteurs de rayonnement hyperfréquence nécessitent que le rayonnement hyperfréquence qui est utilisé pour détecter la cible soit suffisant, même à grande distance. Pour cette raison, les ensembles de blindage existants ne sont pas bien adaptés pour de telles situations, dans lesquelles l'intensité du rayonnement hyperfréquence est fortement variable en cours d'utilisation ou de mission.

A partir de cette situation, un premier objectif de l'invention consiste à fournir des ensembles de blindage qui peuvent posséder initialement des efficacités de blindage différentes, adaptées à des utilisations distinctes de chacun d'eux, tout en ayant des prix unitaires qui sont réduits.

Un second objectif de l'invention consiste à fournir des ensembles de blindage qui soient adaptés à des utilisations ou des missions lors desquelles le rayonnement hyperfréquence possède une intensité qui varie fortement, alors qu'une partie de ce rayonnement hyperfréquence peut être utile.

Pour atteindre l'un au moins de ces objectifs ou d'autres, la présente invention propose un ensemble de blindage tel que décrit précédemment, mais dans lequel le dispositif de connexion électrique est adapté pour produire une valeur variable pour une résistance électrique qui est effective entre chaque première borne et chaque seconde borne. Cette valeur de résistance électrique est soit ajustable par un opérateur, soit variable automatiquement entre au moins deux niveaux d'intensité du rayonnement hyperfréquence. Autrement dit, dans ce dernier cas, la résistance électrique a une première valeur pour un premier niveau d'intensité du rayonnement hyperfréquence, et une seconde valeur pour un second niveau d'intensité du rayonnement hyperfréquence, la première valeur de résistance électrique étant inférieure à la seconde valeur de résistance électrique alors que le premier niveau d'intensité du rayonnement hyperfréquence est supérieur au second niveau d'intensité du rayonnement hyperfréquence.

Ainsi l'invention propose des ensembles de blindage qui permettent chacun d'ajuster l'efficacité de blindage dans l'une au moins des conditions suivantes :
- soit un ajustement initial qui peut être effectué par un opérateur, notamment en fonction du système de détection auquel l'ensemble de blindage est destiné, ou en fonction de l'utilisation qui est prévue pour le système de détection. La résistance du dispositif de connexion électrique de l'ensemble de blindage peut ensuite rester constante pendant toute la durée de vie de l'ensemble de blindage. Mais l'ajustement possible de la résistance du dispositif de connexion électrique, après la fabrication de l'ensemble de blindage, permet d'utiliser des ensembles de blindage identiques pour des systèmes de détection dont les cahiers des charges sont différents ; et
- soit une variation de la résistance du dispositif de connexion électrique qui est réalisée automatiquement au cours de l'utilisation du système de détection, en temps réel en fonction du niveau d'intensité du rayonnement hyperfréquence qui est reçu par le système de détection.

Un ensemble de blindage conforme à l'invention peut former un hublot ou une fenêtre adaptée pour fermer une ouverture de la partie de coque, et pour être disposée simultanément devant une entrée optique d'un capteur qui est sensible au rayonnement optique. Possiblement, l'ensemble de blindage formant fenêtre ou hublot peut être adapté pour être disposé aussi simultanément devant une entrée d'un capteur sensible à une partie du rayonnement hyperfréquence, en plus du capteur de rayonnement optique.

De façon générale, le dispositif de connexion électrique qui possède la valeur variable de résistance électrique entre les première et seconde bornes, peut être porté par le substrat qui est partiellement transparent pour le rayonnement optique et pour le rayonnement hyperfréquence. De tels modes de réalisation sont particulièrement avantageux et économiques, notamment parce qu'ils réduisent le nombre de composants de l'ensemble de blindage, qui sont séparés ou ne sont pas liés rigidement entre eux.

Le dispositif de connexion électrique réalise un couplage électrique entre la structure bidimensionnelle conductrice et la référence de potentiel électrique, avec une valeur de résistance électrique du couplage qui est ajustable.

Préférablement, le dispositif de connexion électrique peut être adapté pour que la résistance électrique qui est effective entre les première et seconde bornes, soit variable entre une première valeur qui est supérieure à 5 fois une valeur de résistance par carré de la structure bidimensionnelle conductrice, et une seconde valeur qui est inférieure à 1/5^{ème} de la valeur de résistance par carré de la structure bidimensionnelle conductrice. Par ailleurs, la valeur de résistance par carré de la structure bidimensionnelle conductrice peut être comprise entre 0,01 Ω/□ et 20 Ω/□.

De façon générale, la résistance du dispositif de connexion électrique, effective entre la première et la seconde borne, peut varier entre deux valeurs qui ont un quotient d'au moins 10 entre elles, et qui sont respectivement inférieure et supérieure à la valeur de résistance par carré de la structure bidimensionnelle.

La structure bidimensionnelle conductrice peut comprendre au moins l'un parmi une couche d'un métal, de préférence une couche d'argent, une couche d'un oxyde transparent et conducteur, de préférence une couche d'oxyde d'indium dopé à l'étain, et une grille d'un matériau conducteur électriquement, de préférence une grille d'un matériau métallique.

Dans des premiers modes de réalisation de l'invention pour lesquels la résistance électrique peut varier automatiquement au cours d'une utilisation de l'ensemble de blindage, le dispositif de connexion électrique peut comprendre :
- un détecteur de rayonnement hyperfréquence, adapté pour délivrer un signal de détection représentatif d'une intensité du rayonnement hyperfréquence qui est reçu par ce détecteur ;
- un circuit électronique qui est connecté entre les première et seconde bornes, et qui est adapté pour produire la valeur variable de la résistance électrique ; et
- un contrôleur, adapté pour modifier la valeur de la résistance électrique qui est produite par le circuit électronique, en fonction du signal de détection qui est délivré par le détecteur de rayonnement hyperfréquence.

Par exemple, le circuit électronique peut comprendre plusieurs branches qui sont connectées en parallèle, et qui ont chacune une valeur de résistance individuelle, l'une au moins des branches comprenant un commutateur qui est commandé par le contrôleur pour activer ou inhiber un couplage électrique qui est produit par cette branche entre la structure bidimensionnelle et la partie de coque.

Alternativement, le circuit électronique peut comprendre au moins un composant électrique qui est résistif à au moins une fréquence comprise entre 0,1 GHz et 40 GHz, et dont une valeur de résistance de ce composant, effective à la fréquence considérée, est variable en fonction d'une tension de contrôle qui est appliquée au composant. Cette tension de contrôle est alors commandée par le contrôleur de façon à la modifier en fonction du signal de détection qui est délivré par le détecteur. Le composant à résistance variable pour la fréquence considérée peut être une diode PIN, par exemple, ou bien une portion d'un matériau à transition métal-isolant qui intercalée entre deux électrodes, et qui est en contact avec celles-ci.

Dans des deuxièmes modes de réalisation de l'invention pour lesquels la résistance du dispositif de connexion électrique peut aussi varier automatiquement au cours d'une utilisation de l'ensemble de blindage, le dispositif de connexion électrique peut comprendre :
- un détecteur de rayonnement hyperfréquence, adapté pour délivrer un signal de détection représentatif d'une intensité du rayonnement hyperfréquence qui est reçu par ce détecteur ;
- une portion d'un matériau thermosensible à transition métal-isolant, qui est connectée électriquement entre les première et seconde bornes, et qui est adaptée pour produire la valeur variable de la résistance électrique en fonction d'une température de cette portion de matériau thermosensible ;
- un moyen de régulation thermique, qui est agencé pour modifier une température de la portion du matériau thermosensible ; et
- un contrôleur, qui est adapté pour activer le moyen de régulation thermique en fonction du signal de détection délivré par le détecteur de rayonnement hyperfréquence.

Le matériau thermosensible à transition métal-isolant peut comprendre un oxyde de vanadium, par exemple VO₂ ou V₂O₃, du sulfure de baryum et de vanadium (BaVS₃), un oxyde de nickel et de praséodyme (PrNiO₃), un oxyde de nickel et de néodyme (NdNiO₃), un oxyde de lanthane et de cobalt (LaCoO₃), un oxyde de fer (Fe₃O₄), du sulfure de nickel (NiS), un oxyde de niobium, notamment NbO₂, un oxyde de titane (TiO₂ ou Ti₂O₃), un oxyde de nickel et de samarium (SmNiO₃), ou encore un mélange ou une composition solide qui comprend l'un au moins de ces matériaux. Ces matériaux à transition métal-isolant, ainsi que d'autres, sont connus de l'Homme du métier et largement documentés dans la littérature disponible.

Dans des troisièmes modes de réalisation de l'invention pour lesquels la résistance électrique peut encore varier automatiquement, le dispositif de connexion électrique peut comprendre une portion d'un matériau à transition métal-isolant qui est sensible à une intensité du rayonnement hyperfréquence, et qui est apte à produire la valeur variable de résistance électrique en réponse à une variation de l'intensité du rayonnement hyperfréquence, lorsque cette portion est exposée pour recevoir ce rayonnement hyperfréquence. Dans ce cas, la portion du matériau à transition métal-isolant qui est sensible à l'intensité du rayonnement hyperfréquence peut être portée par le substrat de l'ensemble de blindage. Le prix unitaire de l'ensemble de blindage peut alors être réduit dans une mesure supplémentaire. Eventuellement, la portion du matériau à transition métal-isolant qui est sensible à l'intensité du rayonnement hyperfréquence peut constituer une partie au moins de la structure bidimensionnelle conductrice. De façon générale pour de tels troisièmes modes de réalisation de l'invention, le matériau qui est sensible à l'intensité du rayonnement hyperfréquence peut être l'un de ceux à transition métal-isolant cités pour les seconds modes de réalisation de l'invention. En effet, de façon générale, un matériau à transition métal-isolant qui est sensible à une variation de température, est aussi sensible à un champ électrique externe, notamment un champ électrique statique ou un champ électrique de rayonnement hyperfréquence.

Un second aspect de l'invention propose un système de détection qui comprend :
- un capteur optique, qui est sensible à du rayonnement optique ;
- optionnellement un capteur de rayonnement hyperfréquence, qui est sensible à une partie d'un rayonnement hyperfréquence ;
- au moins une partie d'une coque conductrice électriquement, qui entoure le capteur optique, et le capteur de rayonnement hyperfréquence le cas échéant, et qui comporte une ouverture ; et
- un ensemble de blindage qui est conforme au premier aspect de l'invention, cet ensemble de blindage étant disposé devant une entrée optique du capteur optique, et optionnellement aussi devant une entrée de rayonnement du capteur de rayonnement hyperfréquence, en fermant l'ouverture de la partie de coque.

Chaque première borne du dispositif de connexion électrique de l'ensemble de blindage est alors raccordée électriquement à la structure bidimensionnelle conductrice, et chaque seconde borne du même dispositif de connexion électrique est simultanément raccordée électriquement à la partie de coque.

D'autres particularités et avantages de la présente invention apparaîtront dans la description ci-après d'exemples de réalisation non limitatifs, en référence aux dessins annexés, dans lesquels :
- la figure 1 représente un système de détection auquel peut être appliquée l'invention ;
- la figure 2 est une vue en plan d'un hublot pouvant être constitué par ensemble de blindage conforme à l'invention ; et
- les figures 3a-3e illustrent cinq modes de réalisation possibles de l'invention.

Pour raison de clarté, les dimensions des éléments qui sont représentés dans ces figures ne correspondent ni à des dimensions réelles ni à des rapports de dimensions réels. En outre, des références identiques qui sont indiquées dans des figures différentes désignent des éléments identiques ou qui ont des fonctions identiques.

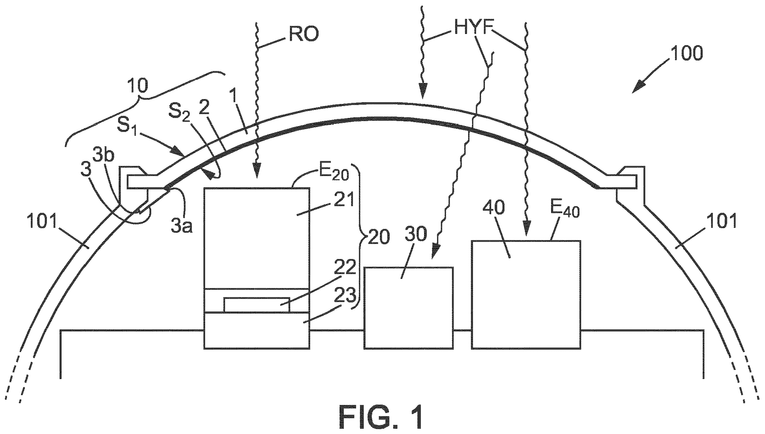

Conformément à la figure 1, un système de détection 100 comporte une partie de coque 101, un ensemble de blindage 10 et au moins un capteur optique 20. Il peut comprendre en outre optionnellement un capteur de rayonnement hyperfréquence 40 et un détecteur de rayonnement hyperfréquence 30, qui seront décrits plus loin.

Par exemple, le système de détection 100 peut avoir une configuration de boule mobile, et être destiné à être embarqué à bord d'un véhicule autopropulsé. Possiblement, les capteurs du système de détection 100, dont le capteur optique 20 et aussi éventuellement le capteur de rayonnement hyperfréquence 40, peuvent participer à détecter une cible externe, vers laquelle l'engin autopropulsé va être dirigé.

La partie de coque 101 est conductrice électriquement, par exemple constituée en un matériau métallique ou en un matériau composite à base de fibres de carbone. Elle constitue une masse électrique qui peut être considérée comme une référence de potentiel électrique. En outre, la partie de coque 101 entoure le capteur optique 20, avec le capteur de rayonnement hyperfréquence 40 et/ou le détecteur de rayonnement hyperfréquence 30, le cas échéant, en formant une cavité dans laquelle se trouve(nt) ce(s) capteur(s) et/ou détecteur. Ainsi, la portion de coque 101, en dehors de l'ensemble de blindage 10, constitue un écran opaque pour les rayonnements hyperfréquences qui proviennent de l'extérieur.

Le capteur optique 20 est sensible à du rayonnement optique RO dans la bande de longueur d'onde qui est comprise entre 0,1 µm et 15 µm. Ce peut être un capteur d'images, qui comporte de façon connue un objectif 21, un détecteur d'images 22, par exemple du type détecteur d'images matriciel, et une électronique de proximité 23. L'électronique de proximité 23 est destinée notamment à contrôler le fonctionnement du détecteur d'images 22, et à transmettre les signaux de lecture d'images qui sont délivrés par ce dernier, à une unité de traitement déportée (non représentée). Le fonctionnement de l'électronique de proximité 23 peut être perturbé par du rayonnement hyperfréquence HYF, dans la bande de fréquence comprise entre 0,1 GHz et 40 GHz, qui pénètrerait dans la partie de coque 101. En effet, l'entrée optique E₂₀ du capteur optique 20 est nécessairement exposée vers l'extérieur pour recueillir le rayonnement optique RO, mais cette exposition s'applique aussi au rayonnement hyperfréquence HYF, qui peut comprendre une composante adverse de brouillage.

Pour éviter les effets d'une telle composante adverse de brouillage, notamment sur l'électronique de proximité 23, l'ensemble de blindage 10 est conçu pour être opaque au rayonnement hyperfréquence HYF, tout en étant transparent pour le rayonnement optique RO. Toutefois, une efficacité de blindage trop importante pour l'ensemble de blindage 10 peut ne pas être souhaitée. Pour cette raison, la présente invention propose une amélioration de l'ensemble de blindage 10 qui permet d'en ajuster l'efficacité de blindage, soit initialement, lors d'un réglage d'usine par exemple, soit automatiquement pendant une utilisation du système de détection 100. L'ajustement automatique de l'efficacité de blindage de l'ensemble 10, en temps réel pendant son utilisation, peut être utile en particulier lorsque le système de détection 100 comprend le capteur de rayonnement hyperfréquence 40, pour le fonctionnement duquel la réception d'une partie du rayonnement hyperfréquence HYF est néanmoins nécessaire, sans provoquer de saturation ni de dégradation par sur-exposition.

L'ensemble de blindage 10 peut former un hublot de fermeture de la partie de coque 101, qui est disposé devant l'entrée optique E₂₀ du capteur optique 20, et éventuellement aussi devant l'entrée de rayonnement E₄₀ du capteur de rayonnement hyperfréquence 40, et éventuellement en plus devant le détecteur de rayonnement hyperfréquence 30.

L'ensemble de blindage 10 comprend un substrat 1 qui est transparent au rayonnement optique RO et au rayonnement hyperfréquence HYF, entre deux faces opposées de ce substrat 1 qui sont notées S₁ et S₂. Un tel substrat peut être à base de silicium (Si), de germanium (Ge), de sulfure de zinc (ZnS), de silice (SiO₂), d'oxyde d'aluminium (Al₂O₃) ou d'oxyde de magnésium (MgO). Un diamètre du substrat 1 peut être compris entre 5 cm (centimètre) et 50 cm, par exemple.

Pour produire l'efficacité de blindage électromagnétique, le substrat 1 porte une structure bidimensionnelle 2 sur l'une au moins de ses faces S₁ et S₂, par exemple la face S₂ dans le mode de réalisation de l'invention qui est représenté sur la figure 1. La structure bidimensionnelle 2 est conçue pour être transparente pour le rayonnement optique RO, et pour être conductrice électriquement dans une mesure qui est adaptée pour produire un effet de blindage à l'encontre du rayonnement hyperfréquence HYF. Pour cela, la structure bidimensionnelle 2 peut avoir l'une des configurations suivantes, qui sont citées à titre d'exemples non-limitatifs :
- au moins une couche mince d'un métal, par exemple une couche d'argent (Ag), qui peut être intercalée entre deux couches diélectriques transparentes pour le rayonnement optique RO, les deux couches diélectriques ayant pour but de réduire la réflexion du rayonnement optique RO par rapport à la couche métallique seule ;
- au moins une couche d'un oxyde transparent et conducteur, par exemple une couche d'oxyde d'indium dopé à l'étain (ITO), éventuellement associée à au moins une autre couche diélectrique et transparente pour le rayonnement RO, encore dans le but de réduire la réflexion du rayonnement optique RO par rapport à la couche d'oxyde transparent conducteur seule ;
- une grille d'un matériau conducteur électriquement, par exemple une grille de cuivre (Cu) ou d'argent (Ag), qui est constituée de rubans imprimés ou de fils du matériau conducteur, et avec laquelle le substrat 1 est dépourvu du matériau conducteur électriquement entre les rubans ou fils de la grille. Eventuellement, le matériau conducteur de la grille peut être superposé à un matériau d'accrochage sur le substrat 1, et possiblement recouvert en outre d'un matériau de protection, notamment de protection contre la corrosion, par exemple une surcouche de titane (Ti). En général, les rubans ou fils d'une telle grille sont opaques pour le rayonnement optique RO, et la transparence pour le rayonnement optique RO résulte d'un taux de couverture du substrat 1 par les rubans ou fils de la grille, qui est limité. Par exemple, ce taux de couverture peut être compris entre 10% et 50%, un pas de rubans ou de fils dans la grille peut être compris entre 1 µm (micromètre) et 10 mm (millimètre), et la grille peut avoir un motif carré. La grille d'un matériau conducteur électriquement peut être associée à au moins une couche diélectrique et transparente pour le rayonnement RO, encore dans le but de réduire la réflexion du rayonnement optique RO par rapport au substrat 1 seul, mais aussi comme protection contre la corrosion de la grille métallique.

Eventuellement, la structure bidimensionnelle 2 peut aussi être constituée d'une grille dont les rubans ou fils sont chacun transparents optiquement, en étant à base d'une ou plusieurs couche(s) mince(s) d'un métal qui est (sont) intercalée(s) entre des couches diélectriques, ou chacun à base d'un oxyde transparent et conducteur.

De telles structures bidimensionnelles 2 peuvent être réalisées sur le substrat 1 par l'un des procédés de dépôt de matériaux connus de l'Homme du métier, tel que la pulvérisation cathodique, l'évaporation, le dépôt chimique en phase vapeur, le dépôt électrolytique, possiblement en combinaison avec une ou plusieurs étapes de masquage ou de gravure.

De telles configurations pour la structure bidimensionnelle 2 sont connues, si bien qu'il n'est pas nécessaire de les décrire plus ici. Elles peuvent avoir chacune une résistance par carré qui est comprise entre 10⁻² Ω/□ (ohm par carré) et 20 Ω/□, par exemple. Toutefois, et d'une façon générale pour l'invention, la partie de coque 101 possède préférablement une valeur de résistance par carré qui est inférieure à celle de la structure bidimensionnelle 2. Ainsi, la fonction de masse électrique ou de référence de potentiel électrique est réalisée dans une meilleure mesure par la partie de coque 101 vis-à-vis de la structure bidimensionnelle 2.

De façon connue aussi, la structure bidimensionnelle 2 doit être connectée à la partie de coque 101 pour produire une protection de blindage qui soit efficace. Un dispositif de connexion électrique 3 est prévu pour réaliser une telle connexion. Il établit une connexion électrique entre au moins une première borne 3a qui est raccordée électriquement à la structure bidimensionnelle 2, et au moins une seconde borne 3b qui est raccordée électriquement à la partie de coque 101. Le raccordement de chaque borne 3a à la structure bidimensionnelle 2 peut être réalisé par l'une des techniques connues, telles qu'une soudure de surface ou un pincement avec un doigt de contact qui est conducteur électriquement. De même, de multiples méthodes sont connues pour raccorder chaque borne 3b à la partie de coque 101, y compris l'enfichage d'une borne, le vissage d'une borne, le contact sous pression avec ou sans déformation élastique, etc.

Toutefois, l'efficacité de blindage que produit la structure bidimensionnelle 2 dépend de la valeur d'une résistance électrique du dispositif 3, qui est effective entre les bornes 3a et 3b. Cette efficacité de blindage varie comme une fonction décroissante la valeur de résistance électrique du dispositif 3, par exemple entre une première valeur qui est supérieure à 5 fois la résistance par carré de la structure bidimensionnelle conductrice 2, et une seconde valeur qui est inférieure à 1/5^{ème} de la résistance par carré de la structure bidimensionnelle conductrice 2. Par exemple, le dispositif 3 peut être adapté pour que sa résistance électrique entre les bornes 3a et 3b varie entre une première valeur qui est inférieure à 2.10⁻³ Ω et une seconde valeur qui est supérieure à 100 Ω. La première valeur est de préférence inférieure à la valeur de résistance par carré de la structure bidimensionnelle 2, qui est alors court-circuitée à la partie de coque 101, et la seconde valeur produit une isolation galvanique entre la structure bidimensionnelle 2 et la partie de coque 101.

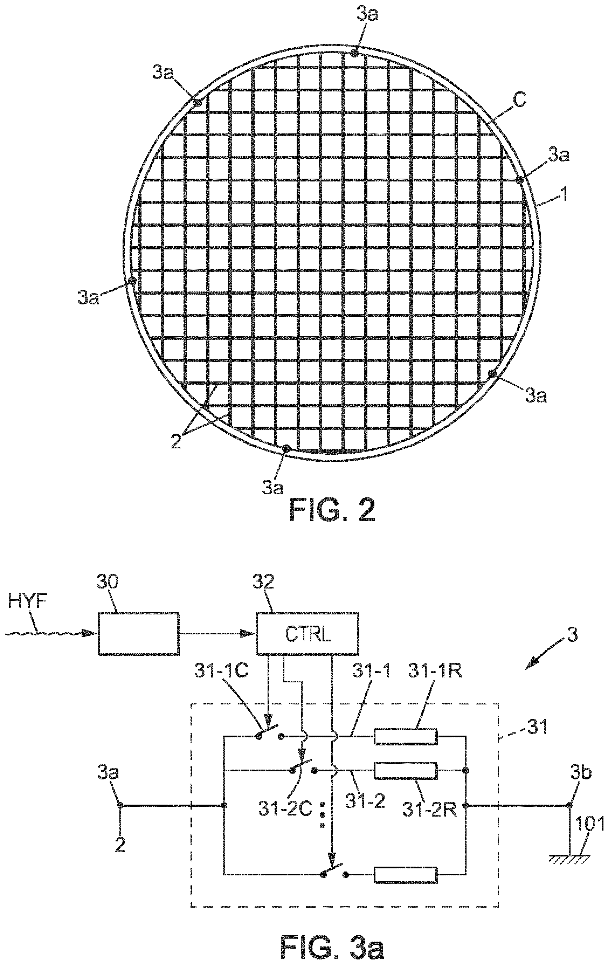

La figure 2 illustre un hublot qui est constitué par un ensemble de blindage conforme à l'invention, et dans lequel la structure bidimensionnelle 2 est une grille métallique qui s'étend sur presque toute la surface utile du substrat 1. Cette grille métallique peut être entourée par une boucle périphérique C, continue et conductrice électriquement. Cette boucle périphérique C peut être formée sur le substrat 1 de la même façon que la grille métallique de la structure bidimensionnelle 2, et éventuellement lors des mêmes étapes de procédés de masquage et de dépôts de matériaux. La boucle périphérique C est alors en contact électrique avec la grille métallique tout autour de celle-ci. Par ailleurs, il peut être avantageux que le dispositif 3 comporte plusieurs bornes 3a, par exemple six bornes 3a, qui sont réparties le long de la boucle C pour réduire des différences entre des résistances électriques qui sont effectives entre n'importe quel endroit de la structure bidimensionnelle 2 et chaque borne 3b (figure 1).

De préférence, le dispositif 3 peut posséder plusieurs bornes 3b qui sont agencées électriquement en parallèle les unes par rapport aux autres, et qui sont destinées à être raccordées électriquement à des endroits différents de la partie de coque 101. Typiquement, les bornes 3b peuvent être réparties et espacées à peu près régulièrement le long de l'interface de montage du substrat 1 dans la partie de coque 101.

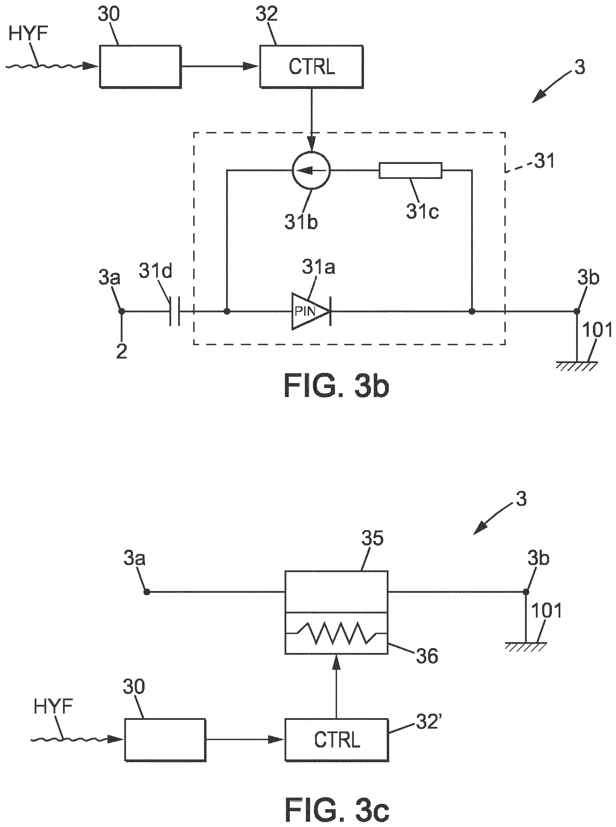

Dans des premiers modes de réalisation du dispositif de connexion électrique 3, qui sont illustrés par les figures 3a et 3b, la variation de la résistance électrique du dispositif 3 est commandée électriquement. Le dispositif 3 comprend alors le détecteur 30 de rayonnement hyperfréquence, un circuit électronique 31, et un contrôleur 32 noté CTRL.

Dans le mode de réalisation de la figure 3a, le circuit électronique 31 comprend plusieurs branches 31-1, 31-2,... qui sont connectées en parallèle entre les bornes 3a et 3b. Chaque branche du circuit 31 comprend une résistance électrique, référencée 31-1R pour la branche 31-1, 31-2R pour la branche 31-2,... qui est connectée en série, à l'intérieur de cette branche, avec un commutateur, référencé 31-1C pour la branche 31-1, 31-2C pour la branche 31-2,... Chaque commutateur peut être individuellement ouvert ou fermé par le contrôleur 32, au moyen d'une commande électrique dédiée. Par ailleurs, le contrôleur 32 reçoit de la part du détecteur 30, un signal qui est représentatif de l'intensité du rayonnement hyperfréquence HYF. Par exemple, au sein du contrôleur 32, l'état ouvert ou fermé à commander pour chaque niveau du signal qui est délivré par le détecteur 30, peut être fourni par une table préenregistrée. Les valeurs respectives des résistances 31-1 R, 31-2R,... sont sélectionnées en fonction des valeurs de l'efficacité de blindage qui sont désirées pour plusieurs niveaux d'intensité du rayonnement hyperfréquence HYF. La valeur de résistance électrique qui est produite par le dispositif 3 résulte alors de la connexion en parallèle des résistances 31-1R, 31-2R,... des branches dont les commutateurs 31-1C, 31-2C,... sont fermés. De nombreuses réalisations alternatives sont possibles pour chacun des commutateurs 31-1C, 31-2C... : à base d'un transistor, à base d'un système micro-électromécanique, désigné par l'acronyme MEMS, à base d'un système nano-électromécanique, désigné par l'acronyme NEMS, etc, toutes ces réalisations étant bien connues de l'Homme du métier.

Dans le mode de réalisation de la figure 3b, le circuit électronique 31 comprend un composant 31a dont une valeur de résistance électrique qui est effective pour un courant hyperfréquence, est variable en fonction d'une tension de contrôle appliquée à ce composant 31a. Par exemple, le composant 31a peut être une diode PIN, disponible commercialement, par exemple sous forme d'un composant discret, et où l'acronyme PIN désigne le type de diode à zone dopée positivement, couche intermédiaire à conductivité intrinsèque, et zone dopée négativement. La diode PIN 31a est connectée entre les deux bornes 3a et 3b. Le circuit 31 comprend alors une source de tension continue et variable 31b, qui est connectée à la diode PIN 31a pour polariser électriquement cette dernière. Ainsi, la valeur de résistance électrique de la diode PIN 31a, qui est effective pour un courant alternatif à une fréquence comprise entre 0,1 GHz et 40 GHz, dit courant hyperfréquence, peut être ajustée par la tension de polarisation qui est produite par la source 31b. Pour cela, la diode PIN 31a et la source de tension 31b sont assemblées dans une boucle, dite boucle de polarisation, qui peut comprendre en outre une résistance fixe 31c. Le contrôleur 32 commande alors la tension de polarisation qui est produite par la source 31b en fonction du signal de détection d'intensité du rayonnement hyperfréquence HYF, qui est délivré par le détecteur 30. Le courant hyperfréquence qui circule à travers la diode PIN 31a, entre les deux bornes 3a et 3b, est généré par le rayonnement hyperfréquence HYF qui est incident sur la structure bidimensionnelle 2. Eventuellement, un condensateur de découplage 31d peut aussi être inséré entre la borne 3a et la boucle de polarisation.

Possiblement, la diode PIN 31a peut être remplacée par une portion d'un matériau à transition métal-isolant tel que cité ailleurs dans cette description, lorsque cette portion est sensible à un champ électrique statique. La portion peut être enserrée entre deux électrodes, et en contact avec celles-ci, les électrodes étant raccordées électriquement aux bornes 3a et 3b. La source de tension 31b produit alors un champ électrique statique dans la portion du matériau à transition métal-isolant, dont dépend la valeur de résistance électrique qui est effective entre les bornes 3a et 3b.

Dans les modes de réalisation de l'invention qui sont illustrés par les figures 3a et 3b, l'utilisation du détecteur 30 permet donc d'ajuster en temps réel, pendant l'utilisation du système de détection 100, la résistance électrique du dispositif 3 en fonction de l'intensité du rayonnement hyperfréquence HYF. Dans le jargon de l'Homme du métier, un tel ajustement est dit dynamique.

Eventuellement, lorsque l'ajustement de la résistance électrique du dispositif 3 est réalisé initialement, puis sa valeur est conservée pendant toute l'utilisation de l'ensemble de blindage 10, le détecteur 30 peut être supprimé des modes de réalisation des figures 3a et 3b. Le contrôleur 32 est alors utilisé initialement pour ouvrir ou fermer sélectivement chacun des commutateurs 31-1C, 31-2C,..., ou pour fixer initialement la valeur de la tension électrique qui est produite par la source 31b.

Dans des deuxièmes modes de réalisation du dispositif de connexion électrique 3, qui sont illustrés par la figure 3c, la variation de la résistance électrique du dispositif 3 est commandée thermiquement. Le dispositif 3 comprend alors le détecteur 30 de rayonnement hyperfréquence, une portion d'un matériau thermosensible 35, un moyen de régulation thermique 36, et un contrôleur 32' noté CTRL. Le matériau de la portion 35 est sélectionné pour présenter une transition métal-isolant, de sorte que sa résistivité électrique varie dans une très large amplitude en fonction de la température. Ce peut être une portion de dioxyde de vanadium (VO₂). Le moyen de régulation thermique 36 est par exemple une résistance chauffante ou un élément à effet Peltier, ou encore une combinaison des deux pour fonctionner efficacement en refroidissement ou en chauffage. Il est disposé en contact thermique avec la portion de matériau thermosensible 35, de façon à contrôler la température de cette dernière. Il est ainsi possible, par l'intermédiaire du détecteur 30 et du contrôleur 32', de commander la résistance électrique de la portion 35, et donc celle du dispositif 3 entre les bornes 3a et 3b. Pour cela, le contrôleur 32' contrôle le fonctionnement du moyen de régulation thermique 36 en fonction du signal de détection d'intensité du rayonnement hyperfréquence HYF, qui est délivré par le détecteur 30.

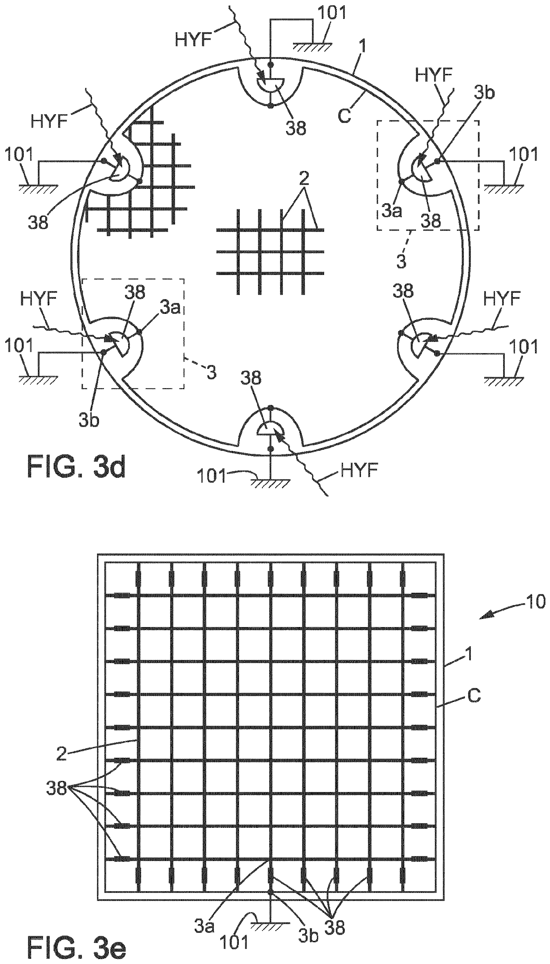

Dans des troisièmes modes de réalisation du dispositif de connexion électrique 3, qui sont illustrés par les figures 3d et 3e, la variation de la résistance électrique du dispositif 3 est produite par au moins une portion 38 d'un matériau qui est directement sensible à l'intensité du rayonnement hyperfréquence HYF. Chaque portion 38 est connectée électriquement entre les bornes 3a et 3b, et son matériau est sélectionné pour produire une résistivité électrique qui dépend de l'intensité du rayonnement hyperfréquence HYF qui est reçu par cette portion. Le matériau de chaque portion 38 peut être notamment du dioxyde de vanadium (VO₂), par exemple avec une épaisseur qui est comprise entre 10 nm (nanomètre) et 10 µm, mesurée perpendiculairement à la face du substrat 1. De façon générale, les matériaux à transition métal-isolant déjà cités conviennent aussi pour ces troisièmes modes de réalisation. Pour de tels modes de réalisation, chaque portion 38 doit être exposée au rayonnement hyperfréquence HYF. Conformément à la figure 3d, la structure bidimensionnelle 2, par exemple une grille métallique telle que décrite plus haut, peut être limitée sur le substrat 1 à l'intérieur de la boucle périphérique C. La boucle périphérique C est conductrice électriquement, aussi portée par le substrat 1 et connectée électriquement à la structure bidimensionnelle 2. Des zones restreintes peuvent alors être prévues sur le substrat 1, à l'extérieur de la boucle périphérique C, entre celle-ci et le bord périphérique du substrat 1. Alors, une portion 38 peut être portée par le substrat 1 dans chacune de ces zones restreintes, avec une borne 3b distincte. Dans chaque zone, la portion 38 est connectée électriquement d'un côté à cette borne 3b, et d'un autre côté à la boucle périphérique C. Les connexions électriques de chaque portion 38 à l'une des bornes 3b et à la boucle périphérique C peuvent être formées lors des étapes de dépôt de matériau et de gravure utilisées pour la boucle périphérique C et la structure bidimensionnelle 2. Chaque borne 3a est alors constituée par le point ou le segment de connexion électrique de l'une des portions 38 avec la boucle périphérique C. Un avantage de tels troisièmes modes de réalisation de l'invention est que le dispositif de connexion électrique 3 à résistance électrique qui est variable, est porté par le substrat 1 avec la structure bidimensionnelle 2. Une réduction de coût et une facilité d'assemblage au sein du système de détection 100 en résultent.

Enfin, la figure 3e illustre une variante possible du mode de réalisation de la figure 3d. Pour raison de clarté et de simplicité de la figure 3e, mais sans limitation quant à toutes les formes possibles pour le substrat 1, celui-ci est représenté avec un bord périphérique qui est carré. La boucle périphérique conductrice C peut alors être parallèle à ce bord carré. La structure bidimensionnelle conductrice 2 peut encore être une grille métallique telle que décrite plus haut, mais qui comporte des portions 38 de matériau sensible au rayonnement hyperfréquence HYF, dans les segments périphériques de cette grille qui la connectent à la boucle périphérique C. En ce sens, les portions 38 constituent des parties de la structure bidimensionnelle conductrice 2. Chaque portion 38 possède donc une première extrémité qui est en contact électrique avec la partie centrale de la structure bidimensionnelle 2, et qui constitue une borne 3a, et une seconde extrémité qui est en contact électrique avec la boucle périphérique C, et qui constitue une borne 3b.

L'Homme du métier comprendra que dans le mode de réalisation de la figure 3e, la partie centrale de la structure bidimensionnelle 2 peut encore posséder une configuration quelconque, notamment à base d'au moins une couche mince métallique qui est intercalée entre deux couches diélectriques, ou à base d'au moins une couche d'oxyde transparent conducteur, comme indiqué plus haut, cette (ces) couche(s) pouvant être continue(s) ou éventuellement pourvue(s) d'évidements.

Dans des variantes des modes de réalisation des figures 3d et 3e, il est possible de remplacer les portions 38 du matériau à transition métal-isolant qui est sensible au rayonnement hyperfréquence, par des portions d'un matériau à transition métal-isolant qui est sensible à un champ électrique statique (DC), ou par des diodes qui sont montées sur le substrat 1, en étant connectées aux bornes 3a et 3b telles qu'indiquées sur ces figures 3d et 3e. Les diodes qui sont ainsi mises en œuvre peuvent être du type PIN évoqué plus haut. Pour de telles variantes, la source de tension 31b est raccordée électriquement entre la partie centrale de la grille métallique qui constitue la structure bidimensionnelle conductrice 2, et la boucle périphérique C.

Enfin, à partir du mode de réalisation de la figure 3e, il est aussi possible de constituer l'ensemble de la structure bidimensionnelle conductrice 2 en matériau à transition métal-isolant qui est sensible à l'intensité du rayonnement hyperfréquence HYF. Si ce matériau est transparent pour le rayonnement optique RO, il peut recouvrir continûment la face du substrat 1 à l'intérieur de la boucle périphérique C. Alternativement, s'il est opaque pour le rayonnement optique RO, la structure bidimensionnelle 2 peut être une grille de ce matériau à transition métal-isolant qui est sensible à l'intensité du rayonnement hyperfréquence HYF, qui est portée par le substrat 1.

Il est entendu que la présente invention peut être reproduite en modifiant certains aspects secondaires de celle-ci par rapport aux modes de réalisation qui ont été décrits en détail ci-dessus, mais tout en conservant certains des avantages cités.

En outre, et d'une façon générale, des valeurs de résistance électrique pour le dispositif 3, à produire pour différents niveaux de l'intensité du rayonnement hyperfréquence HYF, de façon à obtenir des valeurs désirées pour l'efficacité de blindage EB, peuvent être déterminées par des mesures expérimentales ou empiriques, par des simulations numériques paramétriques, ou par des modèles théoriques, sans nécessiter d'activité inventive.

## Revendications

1. Ensemble de blindage électromagnétique transparent optiquement (10), comprenant :
- un substrat (1) rigide ayant deux faces (S₁, S₂) opposées, au moins partiellement transparent entre lesdites deux faces pour au moins un rayonnement électromagnétique qui possède une fréquence comprise entre 0,1 GHz et 40 GHz, dit rayonnement hyperfréquence (HYF), et aussi au moins partiellement transparent entre lesdites deux faces pour un rayonnement optique (RO) qui possède une longueur d'onde comprise entre 0,1 µm et 15 µm ;
- au moins une structure bidimensionnelle (2) conductrice électriquement (11), qui est disposée sur au moins une des faces (S₁, S₂) du substrat (1) et qui est au moins partiellement transparente pour le rayonnement optique (RO) ; et
- un dispositif de connexion électrique (3), qui connecte électriquement au moins une première borne (3a) à au moins une seconde borne (3b), chaque première borne étant raccordée électriquement à la structure bidimensionnelle (2) conductrice, et chaque seconde borne étant destinée à être raccordée électriquement à au moins une partie d'une coque (101) conductrice électriquement,
**caractérisé en ce que** le dispositif de connexion électrique (3) est adapté pour produire une valeur variable pour une résistance électrique qui est effective entre chaque première borne (3a) et chaque seconde borne (3b), la valeur de résistance électrique étant soit ajustable par un opérateur, soit variable automatiquement en fonction d'un niveau d'intensité du rayonnement hyperfréquence (HYF) de sorte que la résistance électrique ait une première valeur pour un premier niveau d'intensité du rayonnement hyperfréquence et une seconde valeur pour un second niveau d'intensité du rayonnement hyperfréquence, ladite première valeur de la résistance électrique étant inférieure à ladite seconde valeur de la résistance électrique alors que ledit premier niveau d'intensité du rayonnement hyperfréquence est supérieur audit second niveau d'intensité du rayonnement hyperfréquence.

2. Ensemble de blindage (10) selon la revendication 1, formant un hublot ou une fenêtre adaptée pour fermer une ouverture de la partie de coque (101), et pour être disposée simultanément devant une entrée optique (E₂₀) d'un capteur (20) qui est sensible au rayonnement optique (RO).

3. Ensemble de blindage (10) selon la revendication 1 ou 2, dans lequel le dispositif de connexion électrique (3) qui possède la valeur variable de résistance électrique entre les première (3a) et seconde (3b) bornes, est porté par le substrat (1) partiellement transparent pour le rayonnement optique (RO) et pour le rayonnement hyperfréquence (HYF).

4. Ensemble de blindage (10) selon l'une quelconque des revendications précédentes, dans lequel le dispositif de connexion électrique (3) est adapté pour que la résistance électrique qui est effective entre les première (3a) et seconde (3b) bornes, soit variable entre une première valeur qui est supérieure à 5 fois une valeur de résistance par carré de la structure bidimensionnelle (2) conductrice, et une seconde valeur qui est inférieure à 1/5^{ème} de la valeur de résistance par carré de ladite structure bidimensionnelle conductrice.

5. Ensemble de blindage (10) selon l'une quelconque des revendications 1 à 4, dans lequel le dispositif de connexion électrique (3) comprend :
- un détecteur de rayonnement hyperfréquence (30), adapté pour délivrer un signal de détection représentatif d'une intensité du rayonnement hyperfréquence (HYF) qui est reçu par le détecteur ;
- un circuit électronique (31) qui est connecté entre les première (3a) et seconde (3b) bornes, et qui est adapté pour produire la valeur variable de la résistance électrique ; et
- un contrôleur (32), adapté pour modifier la valeur de la résistance électrique qui est produite par le circuit électronique (31), en fonction du signal de détection qui est délivré par le détecteur de rayonnement hyperfréquence (30).

6. Ensemble de blindage (10) selon la revendication 5, dans lequel le circuit électronique (31) comprend plusieurs branches (31-1, 31-2,...) connectées en parallèle et ayant chacune une valeur de résistance individuelle, l'une au moins des branches comprenant un commutateur (31-1C, 31-2C,...) commandé par le contrôleur (32) pour activer ou inhiber un couplage électrique qui est produit par ladite branche entre la structure bidimensionnelle (2) et la partie de coque (101).

7. Ensemble de blindage (10) selon la revendication 5, dans lequel le circuit électronique (31) comprend au moins un composant (31a) qui est résistif à au moins une fréquence comprise entre 0,1 GHz et 40 GHz, une valeur de résistance dudit composant, effective à ladite fréquence, étant variable en fonction d'une tension de contrôle qui est appliquée audit composant, et qui est commandée par le contrôleur (32) de façon à modifier ladite tension de contrôle en fonction du signal de détection délivré par le détecteur de rayonnement hyperfréquence (30).

8. Ensemble de blindage (10) selon l'une quelconque des revendications 1 à 4, dans lequel le dispositif de connexion électrique (3) comprend :
- un détecteur de rayonnement hyperfréquence (30), adapté pour délivrer un signal de détection représentatif d'une intensité du rayonnement hyperfréquence (HYF) qui est reçu par le détecteur ;
- une portion (35) d'un matériau thermosensible à transition métal-isolant, qui est connectée électriquement entre les première (3a) et seconde (3b) bornes, et qui est adaptée pour produire la valeur variable de la résistance électrique en fonction d'une température de ladite portion de matériau thermosensible ;
- un moyen de régulation thermique (36), agencé pour modifier une température de la portion (35) du matériau thermosensible ; et
- un contrôleur (32'), adapté pour activer le moyen de régulation thermique (36) en fonction du signal de détection délivré par le détecteur de rayonnement hyperfréquence (30).

9. Ensemble de blindage (10) selon l'une quelconque des revendications 1 à 4, dans lequel le dispositif de connexion électrique (3) comprend une portion (38) d'un matériau à transition métal-isolant qui est sensible à une intensité du rayonnement hyperfréquence (HYF), et qui est apte à produire la valeur variable de résistance électrique en réponse à une variation de l'intensité du rayonnement hyperfréquence, lorsque ladite portion est exposée pour recevoir ledit rayonnement hyperfréquence.

10. Ensemble de blindage (10) selon la revendication 9, dans lequel la portion (38) du matériau à transition métal-isolant qui est sensible à l'intensité du rayonnement hyperfréquence (HYF), est portée par le substrat (1).

11. Ensemble de blindage (10) selon la revendication 9 ou 10, dans lequel la portion (38) du matériau à transition métal-isolant qui est sensible à l'intensité du rayonnement hyperfréquence (HYF), constitue une partie au moins de la structure bidimensionnelle (2) conductrice.

12. Système de détection (100) comprenant :
- un capteur optique (20), qui est sensible à un rayonnement optique (RO) ;
- au moins une partie d'une coque (101) conductrice électriquement, qui entoure le capteur optique (20) et qui comporte une ouverture ; et
- un ensemble de blindage (10) qui est conforme à l'une quelconque des revendications précédentes, ledit ensemble de blindage étant disposé devant une entrée optique (E₂₀) du capteur optique (RO), en fermant l'ouverture de la partie de coque (101),
chaque première borne (3a) du dispositif de connexion électrique (3) de l'ensemble de blindage (10) étant raccordée électriquement à la structure bidimensionnelle (2) conductrice, et chaque seconde borne (3b) dudit dispositif de connexion électrique étant raccordée électriquement à la partie de coque (101).

13. Système de détection (100) selon la revendication 12, comprenant en outre :
- un capteur de rayonnement hyperfréquence (40), qui est sensible à une partie du rayonnement hyperfréquence (HYF),
et dans lequel l'ensemble de blindage (10) est aussi disposé devant une entrée de rayonnement (E₄₀) du capteur de rayonnement hyperfréquence (40), en plus d'être disposé devant l'entrée optique (E₂₀) du capteur optique (20).

## Patentansprüche

1. Optisch transparente elektromagnetische Abschirmungsanordnung (10), welche umfasst:
- ein starres Substrat (1) mit zwei gegenüberliegenden Seiten (S₁, S₂), das zwischen den zwei Seiten wenigstens teilweise transparent für wenigstens eine elektromagnetische Strahlung ist, welche eine Frequenz zwischen 0,1 GHz und 40 GHz besitzt, hyperfrequente Strahlung (HYF) genannt, und außerdem zwischen den zwei Seiten wenigstens teilweise transparent für eine optische Strahlung (RO) ist, welche eine Wellenlänge zwischen 0,1 µm und 15 µm besitzt;
- wenigstens eine elektrisch leitfähige (11) zweidimensionale Struktur (2), welche auf wenigstens einer der Seiten (S₁, S₂) des Substrats (1) angeordnet ist und welche wenigstens teilweise transparent für die optische Strahlung (RO) ist; und
- eine elektrische Verbindungsvorrichtung (3), welche wenigstens eine erste Anschlussklemme (3a) mit wenigstens einer zweiten Anschlussklemme (3b) elektrisch verbindet, wobei jede erste Anschlussklemme an die leitfähige zweidimensionale Struktur (2) elektrisch angeschlossen ist und jede zweite Anschlussklemme dazu bestimmt ist, an wenigstens einen Teil einer elektrisch leitfähigen Schale (101) elektrisch angeschlossen zu werden,
**dadurch gekennzeichnet, dass** die elektrische Verbindungsvorrichtung (3) dafür ausgelegt ist, einen variablen Wert für einen elektrischen Widerstand zu erzeugen, welcher zwischen jeder ersten Anschlussklemme (3a) und jeder zweiten Anschlussklemme (3b) wirksam ist, wobei der elektrische Widerstandswert entweder durch einen Bediener einstellbar ist oder in Abhängigkeit von einem Intensitätsniveau der hyperfrequenten Strahlung (HYF) automatisch variabel ist, derart, dass der elektrische Widerstand einen ersten Wert für ein erstes Intensitätsniveau der hyperfrequenten Strahlung und einen zweiten Wert für ein zweites Intensitätsniveau der hyperfrequenten Strahlung hat, wobei der erste Wert des elektrischen Widerstands kleiner als der zweite Wert des elektrischen Widerstands ist, wenn das erste Intensitätsniveau der hyperfrequenten Strahlung größer als das zweite Intensitätsniveau der hyperfrequenten Strahlung ist.

2. Abschirmungsanordnung (10) nach Anspruch 1, welche eine Luke oder ein Fenster bildet, die bzw. das dafür ausgelegt ist, eine Öffnung des Schalenteils (101) zu schließen und gleichzeitig vor einem optischen Eingang (E₂₀) eines Sensors (20) angeordnet zu werden, welcher für die optische Strahlung (RO) empfindlich ist.

3. Abschirmungsanordnung (10) nach Anspruch 1 oder 2, wobei die elektrische Verbindungsvorrichtung (3), welche den variablen Wert des elektrischen Widerstands zwischen der ersten (3a) und der zweiten (3b) Anschlussklemme besitzt, von dem für die optische Strahlung (RO) und für die hyperfrequente Strahlung (HYF) teilweise transparenten Substrat (1) getragen wird.

4. Abschirmungsanordnung (10) nach einem der vorhergehenden Ansprüche, wobei die elektrische Verbindungsvorrichtung (3) dafür ausgelegt ist, dass der elektrische Widerstand, welcher zwischen der ersten (3a) und der zweiten (3b) Anschlussklemme wirksam ist, variabel ist zwischen einem ersten Wert, welcher größer als das 5-Fache eines Wertes des Flächenwiderstands der leitfähigen zweidimensionalen Struktur (2) ist, und einem zweiten Wert, welcher kleiner als 1/5 des Wertes des Flächenwiderstands der leitfähigen zweidimensionalen Struktur ist.

5. Abschirmungsanordnung (10) nach einem der Ansprüche 1 bis 4, wobei die elektrische Verbindungsvorrichtung (3) umfasst:
- einen Detektor für hyperfrequente Strahlung (30), der dafür ausgelegt ist, ein Detektionssignal zu liefern, das für eine Intensität der hyperfrequenten Strahlung (HYF) repräsentativ ist, welche durch den Detektor empfangen wird;
- eine elektronische Schaltung (31), welche zwischen die erste (3a) und zweite (3b) Anschlussklemme geschaltet ist und welche dafür ausgelegt ist, den variablen Wert des elektrischen Widerstands zu erzeugen; und
- eine Steuereinheit (32), die dafür ausgelegt ist, den Wert des elektrischen Widerstands, welcher von der elektronischen Schaltung (31) erzeugt wird, in Abhängigkeit von dem Detektionssignal, welches von dem Detektor für hyperfrequente Strahlung (30) geliefert wird, zu ändern.

6. Abschirmungsanordnung (10) nach Anspruch 5, wobei die elektronische Schaltung (31) mehrere Zweige (31-1, 31-2, ...) umfasst, die parallelgeschaltet sind und jeweils einen individuellen Widerstandswert aufweisen, wobei wenigstens einer der Zweige einen Umschalter (31-1C, 31-2C, ...) umfasst, der von der Steuereinheit (32) gesteuert wird, um eine elektrische Kopplung, welche von dem Zweig zwischen der zweidimensionalen Struktur (2) und dem Schalenteil (101) erzeugt wird, zu aktivieren oder zu sperren.

7. Abschirmungsanordnung (10) nach Anspruch 5, wobei die elektronische Schaltung (31) wenigstens eine Komponente (31a) umfasst, welche resistiv bei wenigstens einer Frequenz zwischen 0,1 GHz und 40 GHz ist, wobei ein Widerstandswert der Komponente, der bei dieser Frequenz wirksam ist, in Abhängigkeit von einer Steuerspannung, welche an die Komponente angelegt wird, variabel ist, und welche von der Steuereinheit (32) so gesteuert wird, dass die Steuerspannung in Abhängigkeit von dem Detektionssignal geändert wird, welches von dem Detektor für hyperfrequente Strahlung (30) geliefert wird.

8. Abschirmungsanordnung (10) nach einem der Ansprüche 1 bis 4, wobei die elektrische Verbindungsvorrichtung (3) umfasst:
- einen Detektor für hyperfrequente Strahlung (30), der dafür ausgelegt ist, ein Detektionssignal zu liefern, das für eine Intensität der hyperfrequenten Strahlung (HYF) repräsentativ ist, welche durch den Detektor empfangen wird;
- einen Abschnitt (35) eines wärmeempfindlichen Materials mit einem Metall-Isolator-Übergang, welcher elektrisch zwischen die erste (3a) und zweite (3b) Anschlussklemme geschaltet ist und welcher dafür ausgelegt ist, den variablen Wert des elektrischen Widerstands in Abhängigkeit von einer Temperatur des Abschnitts eines wärmeempfindlichen Materials zu erzeugen;
- ein Mittel zur Temperaturregelung (36), das dazu eingerichtet ist, eine Temperatur des Abschnitts (35) des wärmeempfindlichen Materials zu ändern; und
- eine Steuereinheit (32'), die dafür ausgelegt ist, das Mittel zur Temperaturregelung (36) in Abhängigkeit von dem Detektionssignal, das von dem Detektor für hyperfrequente Strahlung (30) geliefert wird, zu aktivieren.

9. Abschirmungsanordnung (10) nach einem der Ansprüche 1 bis 4, wobei die elektrische Verbindungsvorrichtung (3) einen Abschnitt (38) eines Materials mit einem Metall-Isolator-Übergang umfasst, welcher gegenüber einer Intensität der hyperfrequenten Strahlung (HYF) empfindlich ist und welcher geeignet ist, den variablen Wert des elektrischen Widerstands in Reaktion auf eine Änderung der Intensität der hyperfrequenten Strahlung zu erzeugen, wenn der Abschnitt zum Empfangen der hyperfrequenten Strahlung freiliegt.

10. Abschirmungsanordnung (10) nach Anspruch 9, wobei der Abschnitt (38) des Materials mit einem Metall-Isolator-Übergang, welcher gegenüber der Intensität der hyperfrequenten Strahlung (HYF) empfindlich ist, von dem Substrat (1) getragen wird.

11. Abschirmungsanordnung (10) nach Anspruch 9 oder 10, wobei der Abschnitt (38) des Materials mit einem Metall-Isolator-Übergang, welcher gegenüber der Intensität der hyperfrequenten Strahlung (HYF) empfindlich ist, wenigstens einen Teil der leitfähigen zweidimensionalen Struktur (2) bildet.

12. Detektionssystem (100), welches umfasst:
- einen optischen Sensor (20), welcher gegenüber einer optischen Strahlung (RO) empfindlich ist;
- wenigstens einen Teil einer elektrisch leitfähigen Schale (101), welcher den optischen Sensor (20) umgibt und welcher eine Öffnung aufweist; und
- eine Abschirmungsanordnung (10), die einem der vorhergehenden Ansprüche entspricht, wobei die Abschirmungsanordnung vor einem optischen Eingang (E₂₀) des optischen Sensors (RO) angeordnet ist, wobei sie die Öffnung des Teils der Schale (101) schließt,
wobei jede erste Anschlussklemme (3a) der elektrischen Verbindungsvorrichtung (3) der Abschirmungsanordnung (10) an die leitfähige zweidimensionale Struktur (2) elektrisch angeschlossen ist und jede zweite Anschlussklemme (3b) der elektrischen Verbindungsvorrichtung an den Teil der Schale (101) elektrisch angeschlossen ist.

13. Detektionssystem (100) nach Anspruch 12, welches außerdem umfasst:
- einen Sensor für hyperfrequente Strahlung (40), welcher gegenüber einem Teil der hyperfrequenten Strahlung (HYF) empfindlich ist,
und wobei die Abschirmungsanordnung (10) außerdem vor einem Strahlungseingang (E₄₀) des Sensors für hyperfrequente Strahlung (40) angeordnet ist, zusätzlich dazu, dass sie vor dem optischen Eingang (E₂₀) des optischen Sensors (20) angeordnet ist.

## Claims

1. An optically transparent electromagnetic shielding assembly (10), comprising
- a rigid substrate (1) having two opposing faces (S₁, S₂), that is at least partially transparent between said two faces to at least one electromagnetic radiation which has a frequency comprised between 0.1 GHz and 40 GHz, called microwave radiation (HYF), and that is also at least partially transparent between said two faces to an optical radiation (RO) which has a wavelength comprised between 0.1 µm and 15 µm;
- at least one electrically conductive two-dimensional structure (2), which is disposed on at least one of the faces (S₁, S₂) of the substrate (1) and which is at least partially transparent to the optical radiation (RO); and
- an electrical connection device (3), which electrically connects at least one first terminal (3a) to at least one second terminal (3b), each first terminal being electrically connected to the conductive two-dimensional structure (2), and each second terminal being intended to be electrically connected to at least a part of an electrically conductive shell (101),
**characterized in that** the electrical connection device (3) is adapted to produce a variable value for an electrical resistance which is effective between each first terminal (3a) and each second terminal (3b), the electrical resistance value being either adjustable by an operator, or automatically variable as a function of a level of intensity of the microwave radiation (HYF) so that the electrical resistance has a first value for a first level of intensity of the microwave radiation and a second value for a second level of intensity of the microwave radiation, said first value of the electrical resistance being lower than said second value of the electrical resistance whereas said first level of intensity of the microwave radiation is higher than said second level of intensity of the microwave radiation.

2. The shielding assembly (10) as claimed in claim 1, forming a porthole or a window suitable for closing an opening of the part of shell (101), and for being disposed simultaneously in front of an optical input (E₂₀) of a sensor (20) which is sensitive to the optical radiation (RO).

3. The shielding assembly (10) as claimed in claim 1 or 2, in which the electrical connection device (3) which has the variable electrical resistance value between the first (3a) and second (3b) terminals is borne by the substrate (1) that is partially transparent to the optical radiation (RO) and to the microwave radiation (HYF).

4. The shielding assembly (10) as claimed in any one of the preceding claims, in which the electrical connection device (3) is adapted so that the electrical resistance which is effective between the first (3a) and second (3b) terminals is variable between a first value which is greater than 5 times a resistance value per square of the conductive two-dimensional structure (2), and a second value which is less than 1/5^{th} of the resistance value per square of said conductive two-dimensional structure.

5. The shielding assembly (10) as claimed in any one of claims 1 to 4, in which the electrical connection device (3) comprises:
- a microwave radiation detector (30), suitable for delivering a detection signal representative of an intensity of the microwave radiation (HYF) which is received by the detector;
- an electronic circuit (31) which is connected between the first (3a) and second (3b) terminals, and which is suitable for producing the variable value of the electrical resistance; and
- a controller (32), suitable for modifying the value of the electrical resistance which is produced by the electronic circuit (31), as a function of the detection signal which is delivered by the microwave radiation detector (30).

6. The shielding assembly (10) as claimed in claim 5, in which the electronic circuit (31) comprises several branches (31-1, 31-2, etc.) connected in parallel and each having an individual resistance value, at least one of the branches comprising a switch (31-1C, 31-2C, etc.) controlled by the controller (32) to activate or disable an electrical coupling which is produced by said branch between the two-dimensional structure (2) and the part of shell (101).

7. The shielding assembly (10) as claimed in claim 5, in which the electronic circuit (31) comprises at least one component (31a) which is resistive to at least one frequency comprised between 0.1 GHz and 40 GHZ, a resistance value of said component, effective at said frequency, being variable as a function of a control voltage which is applied to said component, and which is controlled by the controller (32) so as to modify said control voltage as a function of the detection signal delivered by the microwave radiation detector (30).

8. The shielding assembly (10) as claimed in any one of claims 1 to 4, in which the electrical connection device (3) comprises:
- a microwave radiation detector (30), suitable for delivering a detection signal representative of an intensity of the microwave radiation (HYF) which is received by the detector;
- a portion (35) of a heat-sensitive material with metal-insulator transition, which is connected electrically between the first (3a) and second (3b) terminals, and which is suitable for producing the variable value of the electrical resistance as a function of a temperature of said portion of heat-sensitive material;
- a thermal regulation means (36), arranged to modify a temperature of the portion (35) of the heat-sensitive material; and
- a controller (32'), suitable for activating the thermal regulation means (36) as a function of the detection signal delivered by the microwave radiation detector (30).

9. The shielding assembly (10) as claimed in any one of claims 1 to 4, in which the electrical connection device (3) comprises a portion (38) of a material with metal-insulator transition which is sensitive to an intensity of the microwave radiation (HYF), and which is capable of producing the variable electrical resistance value in response to a variation of the intensity of the microwave radiation, when said portion is exposed to receive said microwave radiation.

10. The shielding assembly (10) as claimed in claim 9, in which the portion (38) of the material with metal-insulator transition which is sensitive to the intensity of the microwave radiation (HYF), is borne by the substrate (1).

11. The shielding assembly (10) as claimed in claim 9 or 10, in which the portion (38) of the material with metal-insulator transition which is sensitive to the intensity of the microwave radiation (HYF), constitutes at least a part of the conductive two-dimensional structure (2).

12. A detection system (100) comprising:
- an optical sensor (20), which is sensitive to optical radiation (RO);
- at least a part of an electrically conductive shell (101), which surrounds the optical sensor (20) and which includes an opening; and
- a shielding assembly (10) which conforms to any one of the preceding claims, said shielding assembly being disposed in front of an optical input (E₂₀) of the optical sensor (RO), while closing the opening of the part of shell (101),
each first terminal (3a) of the electrical connection device (3) of the shielding assembly (10) being electrically connected to the conductive two-dimensional structure (2), and each second terminal (3b) of said electrical connection device being electrically connected to the part of shell (101).

13. The detection system (100) as claimed in claim 12, further comprising:
- a microwave radiation sensor (40), which is sensitive to part of the microwave radiation (HYF),
and in which the shielding assembly (10) is also disposed in front of a radiation input (E₄₀) of the microwave radiation sensor (40), in addition to being disposed in front of the optical input (E₂₀) of the optical sensor (20).
